# Europäisches Patentamt

# European Patent Office

# Office européen des brevets

(19)

(11) Numéro de publication: **0 116 010**
**B1**

(12) ## FASCICULE DE BREVET EUROPÉEN

(45) Date de publication du fascicule du brevet:
06.04.88

(51) Int. Cl.⁴: **B 23 K 9/12, H 01 L 21/603**

(21) Numéro de dépôt: **84810001.2**

(22) Date de dépôt: **03.01.84**

(54) Agencement pour protéger contre l'étincelage un organe capillaire servant au soudage des fils dans un élément semi-conducteur.

(30) Priorité: **03.01.83 US 455038**

(43) Date de publication de la demande:
**15.08.84 Bulletin 84/33**

(45) Mention de la délivrance du brevet:
**06.04.88 Bulletin 88/14**

(84) Etats contractants désignés:
**AT CH DE FR GB IT LI**

(56) Documents cité:
**EP-A-0 004 787**
**DE-A-3 037 735**

**PATENTS ABSTRACTS OF JAPAN, vol. 6, no. 72 (E-105) 950 , 7 mai 1982, Tokyo, JP;**

(73) Titulaire: **APROVA, General Jewels Co. Ltd., Fabrikstrasse 23, CH- 3250 Lyss (CH)**

(72) Inventeur: **Glutz, Peter, Fabrikstrasse 23, CH- 2350 Lyss (CH)**
Inventeur: **Ellett, Kenneth W., 28 Paul Drive, Northgate San Rafael, CA.94903 (US)**

(74) Mandataire: **Leger, Jean- François, Micheli & Cie 118, rue du Rhône Case postale 47, CH- 1211 Genève 6 (CH)**

## Description

La présente invention concerne les organes capillaires servant au soudage des fils qui relient les pastilles de contact d'une puce aux pôles de son enveloppe ou support, et elle a trait à la protection de ces organes contre l'étincelage et les dépôts charbonneux résultant de l'arc électrique.

Dans la fabrication des éléments semiconducteurs, il est d'usage courant de loger les puces dans des enveloppes. Les connexions électriques entre une puce et son enveloppe sont réalisées par des fils soudés aux pastilles de contact de la puce et aux bornes de sortie de son enveloppe. Selon le type d'élément semiconducteur, ces connexions sont faites à l'aide de fils très fins, dont le diamètre, dans les éléments semiconducteurs courants, est de l'ordre de 25 microns. Ce diamètre peut toutfois aller jusqu'à 500 microns dans les éléments de grande puissance. Ces fils de connexion sont généralement en or ou en aluminium. Plusieurs techniques sont connues pour souder un tel fil à une pastille de contact de la puce et à une borne de sortie de son enveloppe. On se limitera ici aux trois types spécifiques de soudage: (1) thermocompression d'une boule d'or lisse et point de soudure, (2) fixation thermosonique d'une boule d'or lisse et point de soudure et (3) fixation thermosonique ou par ultrasons d'une boule d'aluminium lisse et point de soudure. Ces trois techniques bien connues sont décrites dans "Precision 79 Semiconductor Bonding Handbook" édité par "Small precision Tools, Inc., San Rafael, Californie, USA."

Lors du soudage selon les techniques susmentionnées, le fil, après avoir été soudé à la pastille de contact de la puce et à la borne de sortie de son enveloppe, est cassé au droit de la dernière soudure, puis une boule est formée à son extrémité en vue d'effectuer la connexion suivante.

Actuellement, la boule est formée au moyen d'un arc électrique au charbon, comme décrit ci-après. Auparavant, on utilisait l'arc d'hydrogène, plus faible. Avec ce dernier, la principale cause d'usure des organes capillaires était due à l'abrasion. La durée de vie d'un tel organe, fait en céramique, était communément de un million de soudures. En passant à l'arc au charbon, cette durée de vie est toutefois tombée au-dessous d'un demi-million de soudures. La principale raison de cette chute n'a cependant plus été l'abrasion, mais, d'une part, l'étincelage, qui endommage l'extrémité de l'organe capillaire, et, d'autre part, les dépôts charbonneux, qui se forment à l'intérieur du conduit de cet organe.

Comme cela sera décrit plus en détail ci-après, en référence au dessin annexé, on connait déjà des organes capillaires pour le soudage de fils sur des éléments semi-conducteurs, qui comportent un corps en matériau isolant dont la surface extérieure présente une section tronconique adjacente à une section cylindrique supérieure et terminée à son extrémité inférieure par une face arrondie, ce corps présentant un conduit axial traversant formé de deux sections cylindriques, respectivement supérieure et inférieure, raccordées l'une à l'autre par une section médiane tronconique et dans lequel passe le fil de soudure, mais qui présentent les inconvénients précités.

D'autres types d'organes capillaires pour la soudure de fils sont également connus, par exemple du document JP-A-5 710 944, mais qui sont conçus différemment en ce qu'ils comportent un corps essentiellement formé d'un matériau conducteur et dont la paroi interne du conduit axial pour le fil de soudure est muni d'un revêtement isolant à l'exception de son extrémité inférieure destinée à venir en contact avec la boule formée.

Le but de la présente invention consiste à réduire sur les organes capillaires connus les dommages dus à l'étincelage et les dépôts charbonneux pendant la formation des boules à l'aide de l'arc au charbon en éliminant rapidement de l'organe capillaire le courant de décharge de l'arc.

Le but précité est atteint par l'organe capillaire selon l'invention qui est du type précité et qui est caractérisé par le fait qu'au moins la surface extérieure de la section tronconique du corps ainsi qu'au moins une partie de la surface interne du conduit axial sont munies d'une couche de revêtement en un matériau conducteur. Le corps de l'organe capillaire peut être réalisé en un matériau non conducteur, par exemple en céramique d'alumine à grains fins, et la couche de revêtement ayant une conductibilité électrique supérieure à celle dudit corps peut être en carbure de titane ou de silicium, en nitrure ou en oxyde de silicium, etc. de préférence en nitrure de titane.

Le dessin annexé illustre schématiquement d'une part un organe capillaire de type connu et d'autre part, à titre d'exemple, une forme d'exécution de l'organe capillaire selon la présente invention.

La figure 1 est une coupe d'un organe capillaire de type connu, qui illustre la formation d'une boule à l'aide d'un générateur de décharge ou d'un arc électrique.

La figure 2 est une coupe à plus grande échelle de l'extrémité d'un capillaire, semblable à celui de la figure 1, qui fait voir l'érosion due à l'étincelage.

La figure 3 est une coupe semblable à celle de la figure 2, qui montre jusqu'à quel point l'étincelage peut user l'extrémité d'un organe capillaire non protégé.

La figure 4 est une coupe semblable à celle des figures 2 et 3, qui illustre comment l'arc brûle l'intérieur d'un organe capillaire fait en un matériau conducteur électriquement.

La figure 5 est une coupe à plus petite échelle d'une forme d'exécution de l'organe capillaire selon la présente invention.

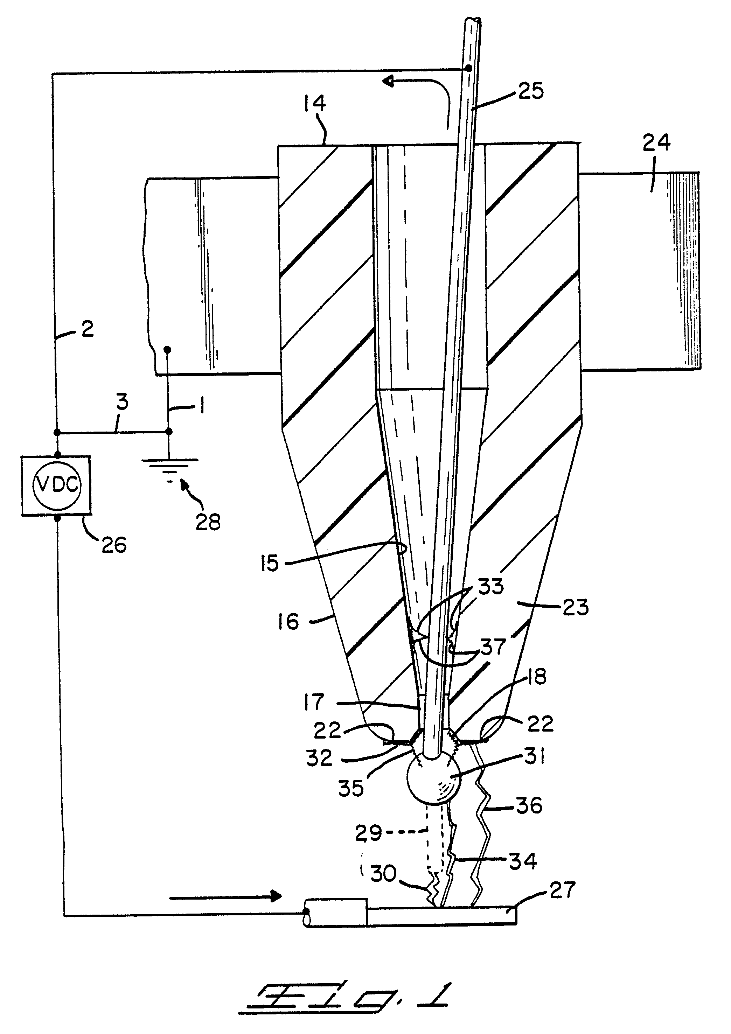

La figure 1 représente un organe capillaire 23, de type connu, qui est en fait en céramique d'alumine à grain fin, contenant environ 99,8 % de $Al_2O_3$, en oxyde de béryllium, en verre, en quartz, en rubis ou saphir polycristallin, en pierre précieuse du groupe corindon, tel que rubis ou saphir ou en d'autres matériaux connus. L'organe 23 est fixé à un support chauffant ou à un transducteur ultrasonique 24 d'une machine à souder. Un fil 25, de préférence en or, passe à travers le conduit central de l'organe 23, qui présente une partie tronconique 15 et un trou capillaire 17. Ce fil pourrait aussi être fait en un autre métal, tel que l'aluminium, un alliage d'aluminium, le palladium, le cuivre, un alliage de cuivre.

Le fil 25 et le support ou transducteur 24 sont mis à la, terre 28 par des conducteurs 1, 2, 3. Un générateur électrique 26 à arc, généralement du type à décharge capacitive, produit des décharges de courant continu à des tensions allant de 700 à 2000 volts. Une borne du générateur 26 est mise à la terre 28 par le conducteur 3, tandis que son autre borne est connectée à une électrode mobile 27. Au repos, cette dernière est écartée de l'organe 23. Lorsqu'il s'agit de former une boule 31, l'électrode 27 est amenée au-dessous de l'organe 23, puis rappprochée de celui-ci, mais sans toucher l'extrémité 29 du fil 25, qui sort de l'organe 23. Quand cette électrode a atteint la position voulue, le générateur 26 est activé de façon à produire une décharge 30 contre l'extrémité 29 du fil 25. La chaleur engendrée par le courant électrique de cette décharge fait fondre cette extrémité 29 du fil 25 au point que le matériel de cette extrémité forme une boule 31 à l'extrémité du fil 25. Dans le dessin, cette extrémité 29 a été représentée en traits interrompus, car elle n'existe plus après que la boule 31 a été formée.

Comme la face de soudage 22 à l'extrémité de l'organe 23 entre normalement en contact avec le fil 25 et le métal des bornes de sortie de l'enveloppe, éventuellement aussi avec la pastille métallisée de la puce pendant le soudage, un mince film métallique 32 se forme sur la face 22. En outre, lorsque le fil 25 est alimenté à travers l'organe 23, il frotte contre la partie tronconique 15 de son conduit, ce qui a pour effet de produire un mince film 33 du métal du fil sur cette surface 15 de l'organe 23. Bien que ce dernier soit fait en matériau non conducteur, les films métalliques 32 et 33 offrent un chemin de moindre résistance au courant électrique de la décharge. Au moment où cette dernière se produit, le fil 25 et la boule 31 sont fortement chargés électriquement. Un étincelage ou un arc électrique 35 se produit alors de la boule 31 et/ou du fil 25 vers le film 32, de même qu'en 37, vers le film 33. Un étincelage ou un arc électrique 36 peuvent aussi se produire directement entre l'électrode 27 et le film 32. A l'endroit où une étincelle atteint le film 32, celui-ci est échauffé et détruit. Le matériau non conducteur de l'organe 23 se trouvant sous ce film est aussi détruit par chaque étincelle, de sorte qu'il en résulte une érosion progressive du chanfrein 18. La nature de cette érosion est semblable à celle qui est produite dans les machines à électro-érosion.

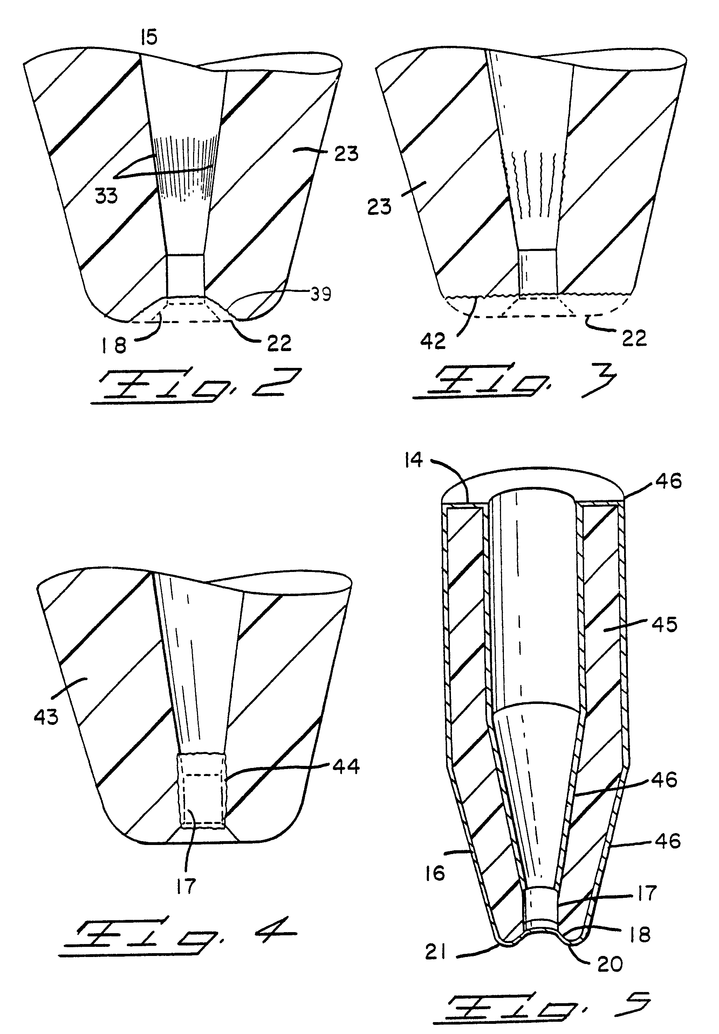

La Fig. 2 montre le dommage 39 causé par l'étincelage à la face 22 d'un organe 23 semblable à celui de la Fig. 1 et fait en matériau non conducteur. L'érosion principale se produit normalement dans la région du chanfrein 18 et dans une partie de la face 22, représentés en traits interrompus. En général, le chanfrein 18 est creusé par l'érosion selon la courbure de la boule 31, ainsi que cela ressort de la zone érodée 39.

L'étincelage ou l'arc électrique 37 (Fig. 1), qui se produit à l'endroit où le fil 25 a frotté contre la surface 15, est moins intense que celui se produisant contre la face 22. Le film 33 est beaucoup moins important que celui qui se forme sur la face 22. La surface 15 est aussi plus éloignée de l'électrode 27 que la face 22. En général, l'étincelage 37 n'érode pas beaucoup la surface 15. Toutefois, il produit une brûlure et par conséquent un dépôt charbonneux qui tend à réduire le diamètre du conduit de l'organe 23 et finit par entraver l'alimentation du fil 25 à travers ce conduit.

Si le film 32 sur la face 22 est plus important (ce qui peut se produire en effectuant par exemple des soudures sur des circuits imprimés), cette face devient bonne conductrice. L'étincelage direct de l'électrode 27 sur cette face en devient plus important. L'érosion s'étend alors à toute cette face 22 (représentée en traits interrompus dans la Fig. 3), qui s'aplatit comme montré en 42 dans cette figure.

En utilisant un organe capillaire fait en un matériau conducteur électriquement tel que le carbure de tungstène ou de titane, comme l'organe 43 de la Fig. 4, l'érosion par étincelage de cet organe se produit principalement dans le trou 17, comme montré en 44. Le courant électrique cherche le chemin de moindre résistance et le trouve en l'occurrence entre le fil 25 et les parois du trou 17 représenté en traits interrompus dans cette figure. L'érosion qui en résulte produit donc un élargissement du conduit de sortie 17 de l'organe 23, ce qui compromet la précision du positionnement des points de soudage du fil 25.

La Fig. 5 est une coupe diamétrale d'un organe capillaire selon la présente invention. Il présente un corps 45 qui peut être fait en l'un ou l'autre des matériaux mentionnés ci-dessus. De préférence, il sera fait toutefois en un matériau non conducteur. Ce corps est revêtu ou plaqué d'une couche conductrice 46. Dans le cas d'un corps 45 fait en matériau conducteur, on choisira une couche 46 dont la conductibilité est nettement supérieure à celle du corps 45. En général, l'épaisseur de la couche 46 n'a pas besoin d'excéder 0,0025 mm. Cette couche 46 doit notamment être assez mince pour adhérer convenablement au corps 45, mais tout de même assez épaisse pour constituer un bon conducteur électrique.

La partie de la couche 46 sur la surface extérieure du corps 45 constitue un chemin de faible résistance aux décharges en provenance de l'électrode 27 à travers la partie 16 de la couche 46, qui revêt la partie tronconique du corps 45 et qui jouxte la face 22. Le courant de ces décharges est ainsi conduit sans dommage à la terre 28 (Fig. 1).

Il convient d'observer que l'organe capillaire de la fig. 5 est destiné à se substituer purement et simplement à celui de la Fig. 1. Le chemin du courant provenant de l'électrode 27 est donc composé de la couche 46 et du support ou du transducteur ultrasonique 24. La couche 46 attire par conséquent les décharges électriques loin de la face 22 et protège ceile-ci de l'érosion.

La couche 46 formée à l'intérieur du corps 45 a le même effet sur l'étincelage représenté en 37 dans la Fig. 1. Le retour à la terre de ce courant provenant du fil 25 se produit à travers la partie de la couche 46 garnissant les parois du conduit capillaire de l'organe 45, 46, la partie de cette couche qui revêt la face 14 du corps 45, sa partie sur la surface extérieure du corps 45 et enfin le support ou le transducteur ultrasonique 24 de la machine à souder. Les dépôts charbonneux sur les parois du conduit de l'organe capillaire sont ainsi pratiquement éliminés.

En pratique, la couche 46 est appliquée sur toutes les surfaces du corps 45. Elie n'aurait toutefois pas besoin de garnir les parois du trou 17 ni la face de soudage 22, comprenant le chanfrein 18 et l'extrémité 20 de l'organe capillaire, ni non plus la partie arrondie externe 21. Comme il serait malaisé d'épargner ces surfaces lors de la formation de la couche 46, celle-ci est déposée partout. A la suite des premières utilisations de cet organe, les décharges électriques auront éliminé le revêtement des parois du trou 17 et de la face 22 et mis le corps 45 à nu. La couche 46 revêtant la partie tronconique 16 qui jouxte la face 22 agira alors comme paratonnerre et attirera les décharges électriques loin de la face 22.

Il suffirait donc en principe de revêtir l'extrémité de la partie tronconique 16 du corps 45 adjacente à la face 22, pourvu que cette partie de revêtement soit mise à la terre, ce qui pourrait être réalisé par d'autres moyens que le support 24.

Une réalisation préférée de l'organe capillaire selon l'invention consiste en un corps fait en céramique d'alumine à grains fins, contenant 99,8 % de $Al_2O_3$ et en une couche conductrice de nitrure de titane appliquée sur ce corps.

## Revendications

1. Organe capillaire (23) pour le soudage de fils sur un élément semiconducteur, comprenant un corps (45) en matériau isolant, dont la surface extérieure présente une section tronconique adjacente à une section cylindrique supérieure et terminée à son extrémité inférieure par une face arrondie, ce corps présentant un conduit axial traversant formé de deux sections cylindriques, respectivement supérieure et inférieure, raccordées l'une à l'autre par une section médiane tronconique et dans lequel passe le fil de soudure (25), caractérisé par le fait qu'au moins la surface extérieure de la section tronconique du corps ainsi qu'au moins une partie de la surface interne du conduit axial sont munies d'une couche de revêtement (46) en un matériau conducteur.

2. Organe capillaire selon la revendication 1, caractérisé par le fait que la totalité de la surface extérieure du corps et de la surface interne du conduit axial est munie d'une couche de revêtement (46) en un matériau conducteur.

3. Organe capillaire selon l'une des revendications 1 et 2, caractérisé par le fait que l'épaisseur de la couche de revêtement est d'environ 0,0025 mm.

4. Organe capillaire selon l'une des revendications 1 à 3, caractérisé par le fait qu'il comporte des moyens de mise à la terre de ladite couche de revêtement.

5. Organe capillaire selon l'une des revendications 1 - 4, caractérisé par le fait que le corps est en céramique d'alumine à grains fins et la couche de revêtement conducteur en nitrure de titane.

## Patentansprüche

1. Kapillarteil (23) für das Schweißen von Drähten auf einem Halbleiterelemnt mit einem Körper (45) aus isolierendem Material, dessen Außenfläche einen kegelstumpfartigen Abschnitt aufweist, der an einen oberen zylindrischen Abschnitt angrenzt und am unteren Ende mit einer abgerundeten Fläche endet, wobei dieser Körper ein durchgebendes, aus zwei zylindrischen, einem oberen und einem unteren, Abschnitten, die mit einem kegelstumpfartigen Mittelteil verbunden sind, gebildetes Axialrohr darstellt, durch das der Schweißdraht (25) geht, dadurch gekennzeichnet, daß zumindest die Außenfläche des kegelstumpfartigen Abschnitts des Körpers sowie mindestens ein Teil der Innenfläche des Axialrohrs eine Überzugsschicht (46) aus einem leitenden Material aufweisen.

2. Kapillarteil nach Anspruch 1, dadurch gekennzeichnet, daß die Gesamtaußenfläche des Körpers und Innenfläche des Axialrohrs eine Überzugsschicht (46) aus einem leitenden Material aufweisen.

3. Kapillarteil nach Anspruch 1 oder 2, dadurch gekennzeichnet, daß die Dicke der Überzugsschicht etwa 0,0025 mm beträgt.

4. Kapillarteil nach einem der Ansprüche 1 - 3, dadurch gekennzeichnet, daß es Erdungsmittel für die Überzugsschicht aufweist.

5. Kapillarteil nach einem der Ansprüche 1 - 4, dadurch gekennzeichnet, daß der Körper aus feinkörniger Aluminiumoxid-Keramik und die leitende Überzugsschicht aus Titannitrid sind.

**Claims**

1. Capillary member (23) for the bonding of wires onto a semiconductor element, comprising a body (45) in insulating material, the external surface of which comprises a troncated conical portion adjacent to an upper cylindrical portion and terminated at its lower end by a rounded face, this body presenting a traversing axial conduit formed of two cylindrical portions, respectively higher and lower, connected the one to the other by means of a troncated conical medial portion and through which the bonding wire (25) passes, characterized by the fact that at least the external surface of the troncated conical portion of the body as well as at least a part of the internal surface of the axial conduit are provided with a coating layer (46) in a conducting material.

2. Capillary member according to claim 1, characterized by the fact that the whole of the external surface of the body and of the internal surface of the axial conduit is provided with a coating layer (46) in a conducting material.

3. Capillary member according to one of claims 1 and 2, characterized by the fact that the thickness of the coating layer is of about 0.0025 mm.

4. Capillary member according to one of claims 1 to 3, characterized by the fact that it comprises means for connecting said coating layer to ground.

5. Capillary member according to one of claims 1 to 4, characterized by the fact that the body is in alumina ceramic with fine grains and the conducting coating layer in titanium nitride.

Fig. 1

15

33

23

39

18

22

_Fig. 2_

23

42

22

_Fig. 3_

43

44

17

_Fig. 4_

14

46

45

46

46

16

17

18

21

20

_Fig. 5_